# EUROPEAN PATENT APPLICATION

(11) **EP 3 660 182 A1**
(43) Date of publication of application: **03.06.2020**
(21) Application number: 19207112.4
(22) Date of filing: 05.11.2019
(51) Int. Cl.: C23C 14/30, C23C 14/46, C23C 14/34, C23C 14/18, C23C 14/08, G02B 1/10, C23C 14/50, H01J 37/34

(54) **FILM FORMING METHOD AND FILM FORMING APPARATUS**

(30) Priority: 26.11.2018 JP 2018219870
(71) Applicant: KONICA MINOLTA, INC., Tokyo 100-7015 (JP)
(72) Inventor: Nose, Masaaki, Tokyo, 100-7015 (JP)
(74) Representative: Hoffmann Eitle

(57) **Abstract**

Provided is a method of forming a film on a substrate with sputtering film formation by an ion beam emitted from an ion source, the method including the steps of: disposing a sputtering target between the substrate and the ion source; and sputtering a surface of the sputtering target opposite to a surface facing the substrate by the ion beam to form a film on the substrate.

## Description

Japanese Patent Application No. 2018-219870, filed on November 26, 2018 with Japan Patent Office, is incorporated herein by reference in its entirety.

### Background

### 1. Technological Field

The present invention relates to a film forming method and a film forming apparatus. More specifically, the present invention relates to a film forming method and a film forming apparatus in which a film forming rate and a material ratio are controlled to uniformly form an extremely thin pure substance film or mixed film as a protective film on a substrate.

### 2. Description of the Related Art

In order to support driving of a vehicle, a vehicle is equipped with an on-vehicle camera. More specifically, a camera for capturing the back and side of a vehicle is mounted on the vehicle body of an automobile, and the image captured by this camera is displayed at a position visible to the driver to reduce the blind spot, thereby it can contribute to safe driving.

Incidentally, the on-vehicle camera is often mounted outside the vehicle, and the lens used has a strict requirement for guaranteeing the environmental resistance. For example, in a salt spray test on a lens, when the light reflectance changes due to the dissolution of SiO₂ which is a component of the anti-reflection film on the lens surface into salt water, it causes ghosts and flares.

Therefore, it is preferable to use a low refractive index material as a main component in the top layer of the lens, and to form a protective film having a small influence on the light reflectance of the lower layer. It is desirable that the film thickness is as thin as possible because the light reflectance of the antireflective film changes if the protective film is a relatively thick protective film having a film thickness of 20 nm or more. If possible, it is desirable to form a protective film having a thickness of 15 nm or less, preferably 10 nm or less.

Here, a technique of simultaneously applying a vapor deposition method and an ion beam sputtering method as a method of forming a thin and uniform protective film (see, for example, Patent Document 1: JP-A 2002-258038) or an ion assisted deposition (hereinafter simply referred to "IAD") method is known (for example, refer to Patent Document 2: JP-A2003-221663 and Patent Document 3: WO 2015/030015).

The IAD method is used as a method of forming a dense film by causing high kinetic energy of ions to act during film formation, or enhancing the adhesion between a film and a substrate. However, when applied to the extremely thin film formation required for the protective film, the circumferential film thickness does not become uniform in the preparation apparatus. Further, when the protective film material is made of mixed materials, there is a problem that the materials are limited to have near vapor pressure, and it is difficult to form a protective film with a desired material ratio and film thickness.

Therefore, in the IAD method, the durability (reliability) required for an outdoor lens such as an on-vehicle application cannot be secured.

### Summary

The present invention has been made in view of the above problems and circumstances. An object of the present invention is to provide a film forming method and a film forming apparatus in which a film forming rate and a material ratio are controlled to uniformly form an extremely thin pure substance film or mixed film as a protective film on a substrate.

A film forming method that reflects an aspect of the present invention is a method of forming a film on a substrate with sputtering film formation by an ion beam emitted from an ion source, the method comprising the steps of: disposing a sputtering target between the substrate and the ion source; and sputtering a specific surface of the sputtering target by the ion beam to form a film on the substrate.

### Brief Description of the Drawings

The advantages and features provided by one or more embodiments of the invention will become more fully understood from the detailed description given hereinbelow and the appended drawings which are given by way of illustration only, and thus are not intended as a definition of the limits of the present invention.
FIG. 1 is a schematic view indicating an example of an IAD vapor deposition apparatus.
FIG. 2 is a schematic view of a conventional sputtering film forming apparatus capable of dual sputtering.
FIG. 3 is a schematic view indicating an example of an ion beam sputtering film forming apparatus according to the present invention.
FIG. 4A is a schematic view indicating an arrangement of sputtering targets when using a plurality of film forming materials.
FIG. 4B is a schematic view indicating an arrangement of sputtering targets when using a plurality of film forming materials.
FIG. 5 is a plan view and a sectional view indicating an arrangement of specific sputtering targets in the case of two film forming materials.
FIG. 6 is a schematic view indicating an example of a film forming apparatus combining an IAD vapor deposition apparatus and an ion beam sputtering apparatus.
FIG. 7 is a sectional view indicating an example of a laminate of an undercoat film and a protective film according to the present invention.

### Detailed Description of the Embodiments

Hereinafter, one or more embodiments of the present invention will be described with reference to the drawings. However, the scope of the invention is not limited to the disclosed embodiments.

The film forming method of the present invention is a film forming method in which sputtering film formation is performed on a substrate by an ion beam emitted from an ion source. In this method, a sputtering target is disposed between the substrate and the ion source. By sputtering a surface of the sputtering target opposite to a surface facing the substrate with an ion beam, a film is formed on the substrate. This feature is a technical feature common or corresponding to the following embodiments.

According to the present invention, it is possible to provide a film forming method and a film forming apparatus in which a film forming rate and a material ratio are controlled to uniformly form an extremely thin pure substance film or mixed film as a protective film on a substrate.

The expression mechanism or action mechanism of the effects of the present invention is as follows.

The film forming method of the present invention is a film forming method in which sputtering film formation is performed on a substrate by an ion beam emitted from an ion source. In this method, a sputtering target is disposed between the substrate and the ion source. By sputtering a surface of the sputtering target opposite to a surface facing the substrate with an ion beam, the scattering speed of the sputtered target particles onto the substrate is delayed, and the film forming rate may be slower than in the conventional method. As a result, the material mixture ratio may be uniformly formed on the substrate while being a very thin protective film. For example, the protective film thus formed becomes a protective film that guarantees excellent environmental resistance without peeling of SiO₂ in a salt spray test while excluding the influence on the light reflectance of the lower layer.

Further, when the ion source is an ion source used for an IAD method, for example, an undercoat film such as a dielectric multilayer film for reflection prevention is formed on a substrate by a vacuum evaporation method using IAD (hereinafter, also referred to as IAD evaporation in the present invention), and then a sputtering target is introduced in the apparatus, followed by sputtering the sputtering target by an ion beam emitted from the ion source. Thus, a protective film having a very small thickness may be formed on the undercoat film. Therefore, the undercoat film and the protective film may be continuously produced by the same apparatus, and a film forming method and a film forming apparatus excellent in production efficiency may be provided.

As an embodiment of the present invention, from the viewpoint of the effects of the present invention, and from the viewpoint of forming a thin film having a uniform film quality, it is preferable that the film forming rate of the sputtering film formation is 10 pm/sec or less.

It is preferable that the above-described ion source is an ion source used for an ion assisted deposition (IAD) method from the viewpoint of production efficiency. For example, a vacuum deposition apparatus (hereinafter, also referred to as an IAD vapor deposition apparatus in the present invention) using an IAD method in which an undercoat film is formed can be used as it is. That is, the undercoat film is formed in advance on the substrate by the IAD method using the ion source, and then the sputtering film formation is performed on the undercoat film using the same ion source. This is a preferable embodiment from the viewpoint of production efficiency.

It is preferable to form a thin film having a film thickness of 15 nm or less by the sputtering film formation from the viewpoint of being able to exclude the influence of the light reflectance on the lower layer as a protective film.

In addition, simultaneously performing sputtering film formation using a plurality of sputtering targets different in at least one of distance, size, and angle forms a protective film simultaneously containing various elements in one sputtering film formation. It is a preferable film forming method from the viewpoint of production efficiency.

Further, it is preferable to perform sputtering film formation while rotating the sputtering target and to perform sputtering film formation while lifting the sputtering target from the same viewpoint.

Preferably, a surface of the sputtering target to be sputtered has a metal surface and a glass surface. When the metal surface contains at least one element of Ti, Cr, Ni and Al, a protective film having salt water resistance may be formed. This is a preferable embodiment.

In addition, a protective film having alkali resistance and acid resistance may be formed by the glass surface being mainly composed of SiO₂ and containing at least one element of Ta, Zr and Na. This is a preferable embodiment.

The film forming apparatus used in the film forming method of the present invention has a means for arranging the sputtering target between the substrate and the ion source at a desired timing. The surface of the target placed opposite to the surface facing the substrate is sputtered by an ion beam emitted from the ion source to form a film on the substrate. By using the film forming apparatus, the undercoat film and the protective film may be continuously produced by the same apparatus. This embodiment is a preferred embodiment from the viewpoint of providing a film forming method and a film forming apparatus excellent in production efficiency.

The present invention and the constitution elements thereof, as well as configurations and embodiments, will be detailed in the following. In the present description, when two figures are used to indicate a range of value before and after "to", these figures are included in the range as a lowest limit value and an upper limit value.

### <<Overview of the film forming method of the present invention>>

The film forming method of the present invention is a film forming method in which sputtering film formation is performed on a substrate by an ion beam emitted from an ion source. A sputtering target is provided between the substrate and the ion source, and a surface of the sputtering target opposite to a surface facing the substrate is sputtered by an ion beam to form a film on the substrate.

The above-mentioned "sputtering film formation" means that a sputtering target (sputtering source) to be a film material is irradiated with an ion beam to generate and scatter sputtered particles, and deposited on an object to be processed such as a substrate to form a film.

The above-mentioned "substrate" refers to an object to be processed in which sputtered particles are generated, scattered and deposited to form a film. An undercoat film, for example, an antireflective film such as a dielectric multilayer film may be formed in advance on the substrate.

The above-mentioned "sputtering target" is a solidified film forming material, and specifically, a metal, a metal oxide, a quartz glass, or a vapor deposition material formed on a glass substrate is used.

As a method of forming a thin film such as the metal oxide on a substrate, there are known evaporation systems such as: vacuum evaporation, ion beam evaporation, and ion plating, and there are known sputtering systems such as: sputtering, ion beam sputtering, and magnetron sputtering. The film forming method of the present invention utilizes an ion source (hereinafter also referred to as an IAD ion source) used in the IAD method for sputtering. It may be a factor to control the film forming rate.

The IAD method is a method in which high kinetic energy of ions acts during film formation to form a dense film or increase the adhesion of the film. For example, an ion beam method is a method in which a deposition material is accelerated by ionized gas molecules emitted from an ion source to form a film on a substrate surface. The IAD method is also referred to as "ion beam assist method".

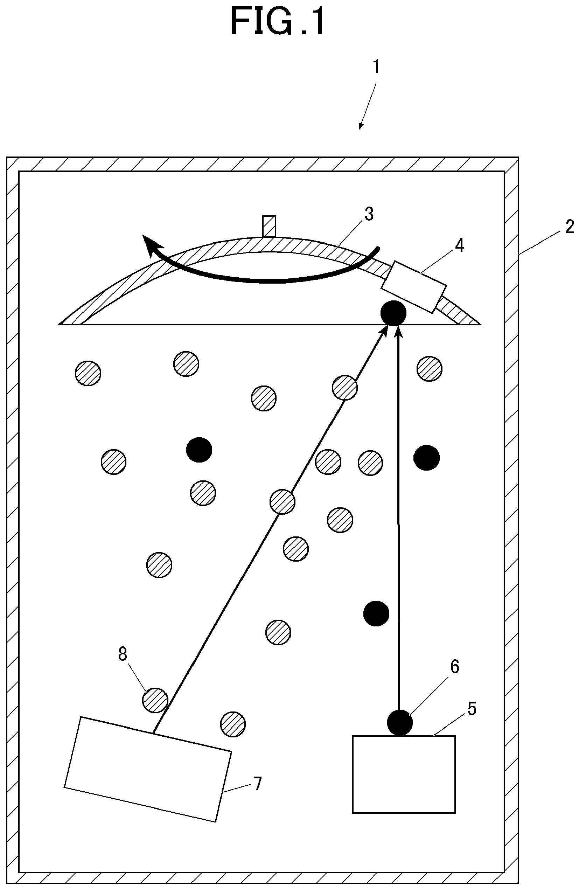

FIG. 1 is a schematic view indicating an example of an IAD vapor deposition apparatus.

The IAD vapor deposition apparatus 1 includes a dome 3 in a chamber 2, and a substrate 4 is disposed along the dome 3. A vapor deposition source 5 is equipped with an electron gun for evaporating the vapor deposition substance, and the vapor deposition substance 6 from the vapor deposition source 5 scatters toward the substrate 4 and condenses and solidifies on the substrate 4. At this time, an ion beam 8 is irradiated toward the substrate from an IAD ion source 7 and the high kinetic energy of the ions is applied during the film formation to form a dense film or enhance the adhesion of the film.

Here, the substrate 4 may be glass or a resin. As a resin, a polycarbonate resin and a cycloolefin resin are mentioned.

At the bottom of the chamber 2, a plurality of deposition sources 5 may be disposed. Here, although one vapor deposition source is indicated as the vapor deposition source 5, the number of the vapor deposition sources 5 may be plural. The film forming material (vapor deposition material) of the vapor deposition source 5 is used to generate a vapor deposition substance 6 by an electron gun. The film forming material is scattered and adhered to a substrate 4 (for example, a glass plate) installed in the chamber 2. Thereby, a layer (for example, a silicon oxide layer) made of a film forming material is formed on the substrate 4.

Further, the chamber 2 is provided with an evacuation system not illustrated, whereby the inside of the chamber 2 is evacuated.

The dome 3 has at least one holder (not illustrated) that holds the substrate 4 and is also called a vapor deposition umbrella. The dome 3 has an arc shape in cross section, and has a rotationally symmetrical shape that passes through the center of a chord connecting both ends of the arc and rotates with an axis perpendicular to the chord as an axis of rotational symmetry. By rotating the dome 3 around the axis, for example, at a constant speed, the substrate 4 held by the dome 3 via the holder revolves around the axis at a constant speed.

The dome 3 can hold a plurality of holders side by side in a rotational radial direction (revolutional radial direction) and a rotational direction (revolutional direction). As a result, it becomes possible to simultaneously form a film on a plurality of substrates 4 held by a plurality of holders, and the manufacturing efficiency of the device may be improved.

The IAD ion source 7 is an apparatus for introducing argon or oxygen gas into the inside of the main body to ionize them, and irradiating the substrate 4 with ionized gas molecules (ion beam 8). As the ion source, a Kauffman type (filament), a hollow cathode type, an RF type, a bucket type, or a duoplasmatron type may be applied. By irradiating the substrate 4 with the above-described gas molecules from the IAD ion source 7, for example, molecules of a film forming material evaporated from a plurality of evaporation sources may be pressed onto the substrate 4. Thereby, a film with high adhesion and high density may be formed on the substrate 4. The IAD ion source 7 is disposed to face the substrate 4 at the bottom of the chamber 2, but may be disposed at a position offset from the opposing axis.

The ion beam used in the AD method is used at a low degree of vacuum and the acceleration voltage tends to be lower than the ion beam used in the ion beam sputtering method. For example, an ion beam with an acceleration voltage of 100 to 2000 V and an ion beam with a current density of 1 to 120 µA/cm² may be used. In the film forming step, the irradiation time of the ion beam may be, for example, 1 to 800 seconds, and the number of particle irradiation of the ion beam may be, for example, 1 x 10¹³ to 5 x 10¹⁷/cm². The ion beam used in the film formation process may be an ion beam of oxygen, an ion beam of argon, or an ion beam of a mixed gas of oxygen and argon.

The monitor system (not illustrated) is a system for monitoring the characteristics of the layer formed on the substrate 4 by monitoring the layer evaporated from each deposition source 5 and attached to itself during vacuum film formation. By this monitor system, optical characteristics (for example, light transmittance, light reflectance, and optical film thickness) of a layer formed on the substrate 4 may be grasped. The monitoring system also includes a quartz crystal thickness monitor, which can also monitor the physical thickness of the layer deposited on the substrate 4. The monitor system also functions as a control unit that controls ON/OFF switching of the plurality of evaporation sources 5, and ON/OFF switching of the IAD ion source 7 according to the layer monitoring result.

In the present invention, it is preferable to form an undercoat film according to the present invention to be described later, for example, a dielectric multilayer film, using the IAD vapor deposition apparatus 1 from the viewpoint of utilizing a high film forming rate.

However, when the above-described vapor deposition apparatus is used to form the extremely thin protective film according to the present invention, the circumferential film thickness does not become uniform in the preparation apparatus. Further, when the protective film material is made of mixed materials, there is a problem that the materials are limited to have near vapor pressure, and it was difficult to form a protective film with a desired material ratio and film thickness.

Therefore, in forming the protective film according to the present invention, it is required a method and apparatus for newly controlling the film forming rate and the composition of the deposition material.

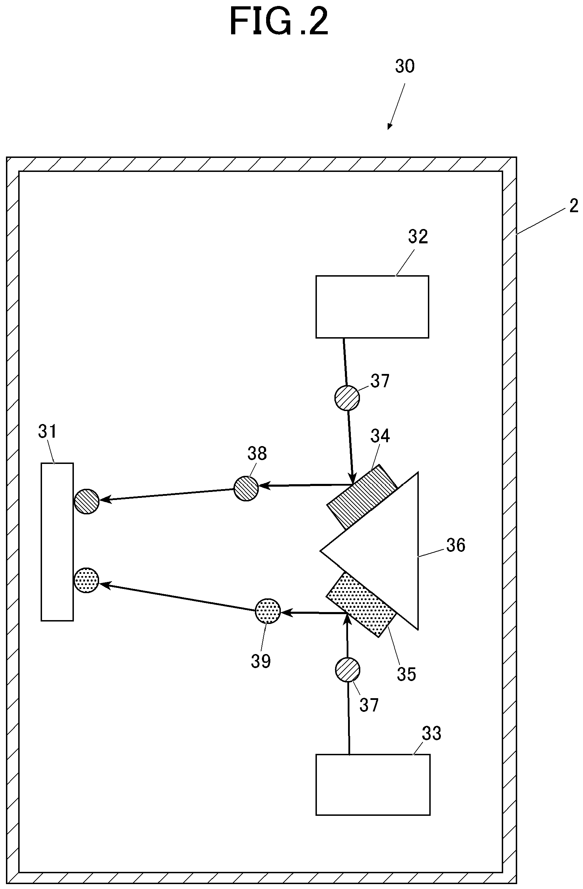

As a method of controlling the film forming rate, JP-A 2017-57487 discloses an ion beam sputtering apparatus using an ion source as an ion beam source for sputtering. This apparatus is capable of simultaneously performing dual sputtering or sputtering and ion assist (IAD) in one apparatus as indicated in FIG. 2. By using an ion beam sputtering apparatus that uses the ion source used in IAD as sputtering, the film forming rate may be reduced compared to the vapor deposition apparatus indicated in FIG. 1.

FIG. 2 indicates a schematic view of a sputtering film forming apparatus capable of dual sputtering described in JP-A 2017-57487.

The sputtering film forming apparatus 30 capable of dual sputtering has a target holder 36 which arrange the positions a first sputtering target 34 and a second sputtering target 35 diagonally. The sputtering target is irradiated with an ion beam 37 from the two rotatable ion sources 32 and 33 facing the respective sputtering targets for sputtering. Two types of first sputtered particles 38 and second sputtered particles 39 are generated and scattered, and a film is deposited and solidified on the substrate 31.

The sputtering film forming apparatus has a mechanism capable of simultaneously performing sputtering and ion assist (IAD) in one apparatus. It is possible to adjust the distance and angle from the two sputtering targets to the substrate so that sputtered particles generated by sputtering are generated and scattered directly toward the substrate side, but the film forming rate is relatively fast. Therefore, from the viewpoint of application to the deposition of the extremely thin protective film according to the present invention, it is presumed that the film forming rate is still too fast and it is difficult to form a uniform thin film. In addition, although it is conceivable to lower the ion beam irradiation intensity for adjusting the film forming rate, it is difficult to process a large area, and the application of the method is not preferable.

In contrast to the film forming methods of these known examples, the film forming method of the present invention is a film forming method of performing sputtering film formation on a substrate by an ion beam emitted from an ion source. A sputtering target is provided between the substrate and the ion source, and a surface of the sputtering target opposite to a surface facing the substrate is sputtered by an ion beam to form a film on the substrate.

### «Specific configuration of the film forming method of the present invention»

The film forming method of the present invention is utilized as an ion beam source for sputtering the ion source used in the IAD method, and the SiO₂ film on the substrate is formed at an unconventional low film forming rate of 10 pm/sec or less. It is characterized in that a mixed film mainly composed of such a metal oxide is formed on the substrate. Since the film forming rate is on the order of pm/sec, a film forming rate on the order of 1/10 to 1/100 is realized as compared with the conventional vapor deposition method and sputtering method, it is possible to produce homogeneous very thin films (e.g., film thickness in the range of 5 nm or less).

Hereinafter, the film forming method of the present invention will be described with reference to the drawings.

### <First embodiment: Film forming method using ion beam sputtering apparatus>

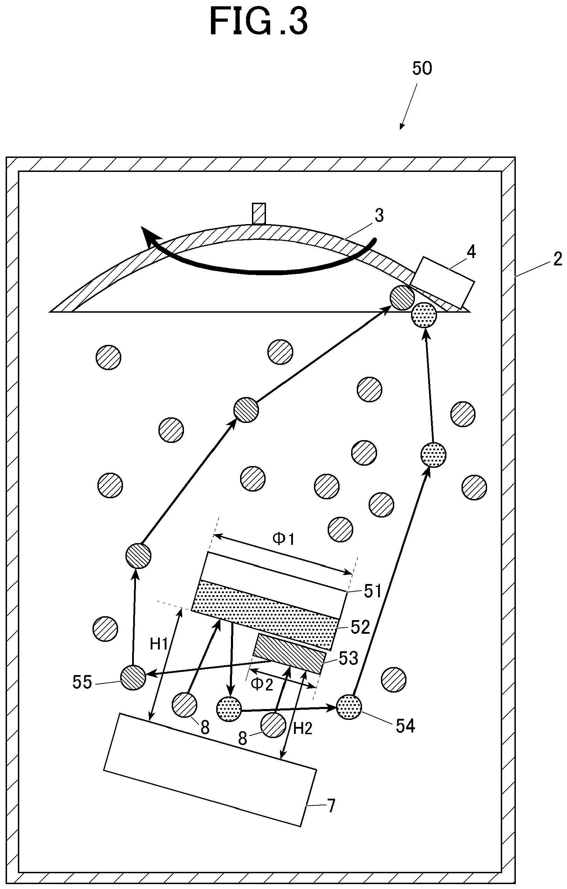

FIG. 3 is a schematic view of an ion beam sputtering film forming apparatus for sputtering by an ion beam emitted from an ion source according to the present invention. However, this figure is an example and the present invention is not limited to this.

An ion beam sputtering film forming apparatus 50 according to the present invention includes a dome 3 in a chamber 2 similarly to the IAD vapor deposition apparatus of FIG. 1, and a substrate 4 is disposed along the dome 3.

The sputtering source is an IAD ion source 7, and an ion beam 8 emitted from the IAD ion source 7 is directed to a first sputtering target 52 and a second sputtering target 53. Although FIG. 3 describes the case of performing dual sputtering, the number of sputtering targets may be one.

The first sputtering target 52 and the second sputtering target 53 are disposed on a target holder 51 located between the substrate 4 and the IAD ion source 7. A surface of the first sputtering target 52 and the second sputtering target 53 opposite to a surface facing the substrate 4 is sputtered by the ion beam 8 from the IAD ion source 7 to generate and scatter sputtered particles 54 and 55, and a film is formed on the substrate 4.

Sputtering targets may be stacked with one or more film deposition materials, and simultaneous multi-source sputtering is possible. In FIG. 3, for example, a first sputtering target 52 mainly composed of TiO₂ and a second sputtering target 53 mainly composed of SiO₂ are disposed in an overlapping manner, and simultaneous dual sputtering is performed.

The feature of the present invention is that the sputtered particles 54 and 55 are generated by sputtering by the ion beam 8 on a surface opposite to a surface facing the substrate 4 and not on the surface directly facing the substrate. Therefore, the sputtered particles 54 and 55 scatter toward the substrate while bypassing the sputtering target to contribute to film formation, and therefore, the film forming rate may be reduced.

Therefore, in addition to the ion beam irradiation time, the control factors of the film forming rate are the size of the sputtering target (Φ in the figure), the distance from the IAD ion source to the sputtering target (H in the figure), the distance from the sputtering target to the substrate 4. Therefore, it is not necessary to perform adjustment such as lowering the ion beam irradiation intensity to adjust the d film forming rate as in the prior art. Compared to known vapor deposition methods and sputtering methods, a film forming rate of 10 pm/sec or less, corresponding to 1/10 to 1/100 of the film forming rate may be realized, and it is possible to produce homogeneous, extremely thin films. The film forming rate is preferably 5 pm/sec or less, more preferably 0.1 to 3 pm/sec.

In addition, from the viewpoint of adjusting the film forming rate, the sputtering target preferably changes the angle facing the IAD ion source, in addition to the distance (H) from the IAD ion source. Further, forming a film by sputtering while rotating the sputtering target, or forming a film by sputtering while lifting the film is also a preferable method from the viewpoint of adjusting the film forming speed and the composition of the film forming material.

Regarding the multi-source sputtering, in the sputtering target according to the present invention, it is preferable that the sputtering surface of the target has a metal surface and a glass surface.

The metal surface preferably contains at least one element of Ti, Cr, Ni and Al from the viewpoint of improving the salt water resistance as a protective film. Further, it is preferable that the glass surface is mainly composed of SiO₂ and contains at least one element of Ta, Zr and Na from the viewpoint of improving the durability against alkali and acid as a protective film and ensuring the environmental resistance.

Further, it is also preferable to use Ta₂O₅, ZrO₂ or ZnO as a sputtering target by changing the components of the glass, from the viewpoint of improving the durability to the alkali and the acid.

The preferable example of arrangement of the film forming material of the sputtering target in the case of performing multi-source sputtering is indicated below.

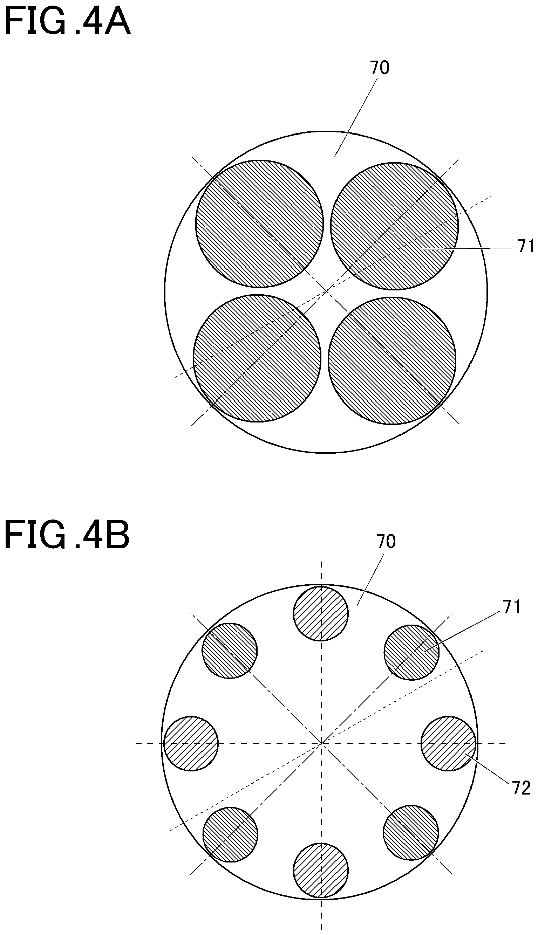

FIG. 4A and FIG. 4B are a schematic view indicating an arrangement of sputtering targets when using a plurality of film forming materials.

FIG. 4A is a schematic view indicating an arrangement of the film forming material in the sputtering target when there are two film forming materials.

A first sputtering target 70, which is the main film forming material, is formed in a disk shape, and second sputtering targets 71, which are film forming materials to be mixed, are arranged opposite to each other along the outer periphery of the first sputtering target. It is preferable to arrange equally at four positions so as to be at an angle of 90°. The circle of the second sputtering target 71 indicates the position of the arrangement, and the size thereof does not indicate the size of the sputtering target.

FIG. 4B is a schematic view indicating an arrangement of the film forming material in the sputtering target when there are three film forming materials.

The first sputtering target 70, which is the main film forming material, is formed in a disk shape, and the second sputtering targets 71, which are film forming materials to be mixed, face each other and are arranged at four positions so as to form an angle of 90°. Further, it is preferable to equally arrange the third sputtering targets 72 at four positions having an angle of 45° with the second sputtering targets 71.

In any case, when sputtering is performed while rotating the sputtering target, the generation of sputtered particles may be made uniform, which is preferable.

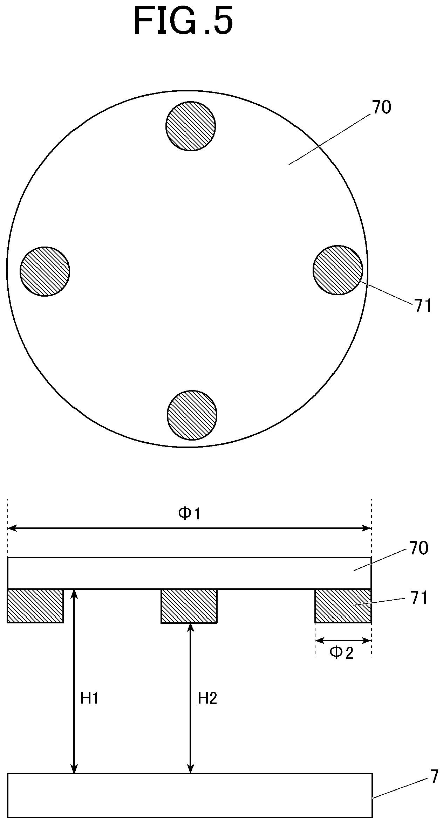

FIG. 5 is a plan view and a sectional view indicating an arrangement of specific sputtering targets in the case of two film forming materials.

The first sputtering target 70, which is the main film forming material, is formed in a disk shape, and the second sputtering targets 71, which are film forming materials to be mixed, face each other, and are evenly arranged at four positions so as to form an angle of 90°.
The size of the first sputtering target 70 is represented by Φ1 (unit mm), and the size of the second sputtering target 71 is represented by Φ2 (unit mm).

The above-described Φ1 is preferably in the range of 100 to 500 mm, and more preferably in the range of 200 to 400 mm. The above-described Φ2 is preferably in the range of 10 to 100 mm, and more preferably in the range of 20 to 80 mm. The thickness of both is preferably in the range of 1 to 5 mm.

The distance from the IAD ion source 7 to the first sputtering target 70 is indicated by H1 (unit mm), and the distance to the second sputtering target 71 is indicated by H2 (unit mm).

The above-described H1 and H2 are preferably in the range of 50 to 200 mm, and more preferably in the range of 100 to 150 mm.

The above-described Φ1, Φ2, H1 and H2 are appropriately determined as control factors of the film forming speed and the mixing ratio.

The film forming apparatus used in the film forming method of the present invention has a means capable of arranging the sputtering target between the substrate and the ion source at a desired timing. A surface opposite to a surface facing the substrate of the sputtering target to be disposed is sputtered by an ion beam emitted from the ion source to form a film on the substrate.

By having a means capable of arranging the sputtering target in the apparatus at a desired timing, the undercoat film is deposited on the substrate by the IAD method using the IAD vapor deposition apparatus indicated in FIG. 1, and then the sputtering target is introduced into the apparatus to face the IAD ion source, as indicated in FIG. 3. The sputtering film formation may be performed in an ion beam sputtering film forming apparatus.

The means by which the sputtering target may be disposed at a desired timing is not particularly limited. As an example, there may be mentioned an introduction means for moving a sputtering target prepared in advance outside the apparatus along a guide rail provided inside the apparatus from a window-like entrance provided in the chamber.

### <Second embodiment: Film forming method using film forming apparatus including IAD vapor deposition apparatus and ion beam sputtering apparatus>

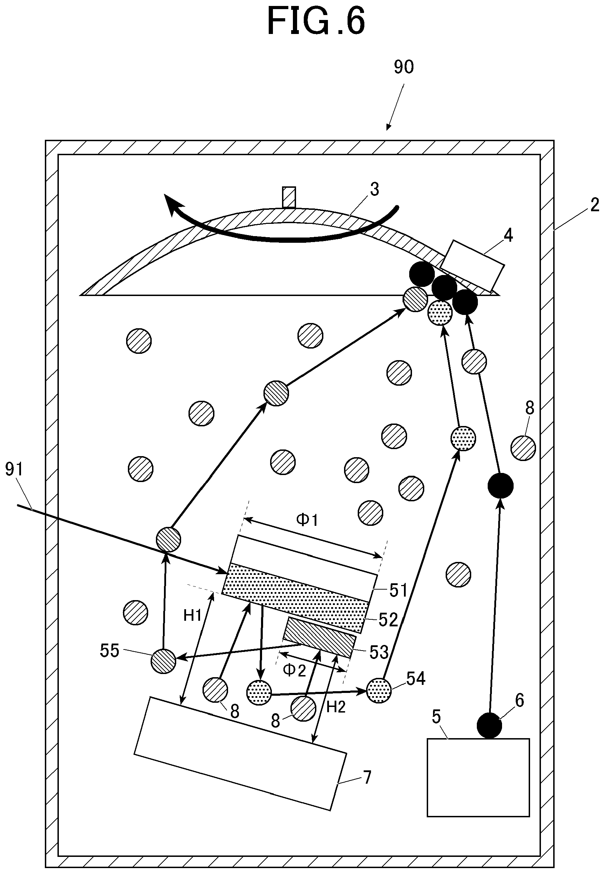

FIG. 6 is a schematic view indicating an example of a film forming apparatus having both an IAD vapor deposition apparatus and an ion beam sputtering apparatus capable of continuously forming an undercoat film and a protective film according to the present invention.

A film forming apparatus 90 includes a dome 3 in a chamber 2 similarly to the vapor deposition apparatus of FIG. 1, and a substrate 4 is disposed along the dome 3. A vapor deposition source 5 is equipped with an electron gun for evaporating the vapor deposition substance, and a vapor deposition substance 6 from the vapor deposition source 5 scatters toward the substrate 4 and condenses and solidifies on the substrate 4. At this time, an ion beam 8 is irradiated toward the substrate from an IAD ion source 7 and the high kinetic energy of the ions is applied during the film formation to form a dense film or enhance the adhesion of the film.

A plurality of vapor deposition sources are prepared.
For example, dielectric multilayer films in which a SiO₂-containing layer which is a low refractive index layer and a Ta₂O₅-containing layer which is a high refractive index layer are alternately laminated is formed as an undercoat film.

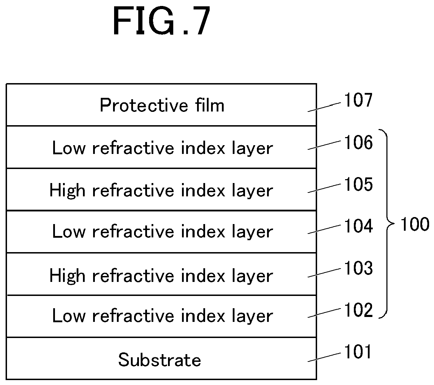

As an example of the dielectric multilayer films, the layer configuration indicated in FIG. 7 is common.

### (Dielectric multilayer films)

The dielectric multilayer films 100 having an antireflection function comprise high refractive index layers 103 and 105 having a refractive index higher than that of the substrate 101, and low refractive index layers 102, 104, and 106 having a refractive index lower than that of the high refractive index layer. It is preferable to have a multilayer structure in which these high refractive index layers and low refractive index layers are alternately laminated. The number of layers is not particularly limited, but preferably 12 or less from the viewpoint of the productivity of the antireflective film.

It is preferable that the refractive index to the wavelength 587.56 nm of the high refractive index layer is in the range of 1.9 to 2.45, and the refractive index to the wavelength 587.56 nm of the low refractive index layer is in the range of 1.3 to 1.5.

The material used for the dielectric multilayer films (second high refractive index layer, low refractive index layer) according to the present invention is preferably, for example, oxides of Ti, Ta, Nb, Zr, Ce, La, Al, Si, and Hf, a combination of these oxides, and MgF₂ are suitable. By stacking multiple layers of different dielectric materials, it is possible to add the function of reducing the reflectance over the entire visible range.

The number of layers depends on the required optical performance, but by laminating approximately 3 to 8 layers, the reflectance of the entire visible region may be reduced. It is preferable that the upper limit number is 12 layers or less from the viewpoint of preventing the film from peeling off due to an increase in film stress.

As a specific configuration of a dielectric multilayer films 100 according to the present invention, as indicated in FIG. 7, a low refractive index layer 102, a high refractive index layer 103, a low refractive index layer 104, a high refractive index layer 105, and a low refractive index layer 106 are sequentially arranged from a substrate 101 side. A protective film 107 according to the present invention is preferably provided on the low refractive index layer 106.

The low refractive index layers 102, 104 and 106 are made of a material having a refractive index lower than that of the substrate 101. The preferable materials therefor are, for example, SiO₂ or a mixture of SiO₂ and Al₂O₃.

The high refractive index layers 103 and 105 are made of a material having a refractive index higher than that of the substrate 101. The preferable materials therefor are, for example, a mixture of an oxide of Ta and an oxide of Ti, an oxide of Ti, an oxide of Ta, a mixture of an oxide of La and an oxide of Ti.

Further, the thickness of the dielectric multilayer films (the total thickness in the case of laminating a plurality of layers) is preferably in the range of 50 nm to 5 µm. When the thickness is 50 nm or more, it is possible to exhibit anti-reflection optical characteristics, and when the thickness is 5 µm or less, it is possible to prevent surface deformation due to film stress of the multilayer films itself.

As a film forming condition for depositing a film forming material which is a silicon oxide or tantalum oxide constituting dielectric multilayer films on a substrate, the following conditions are preferably mentioned, for example: the level of reduced pressure in the chamber is usually in the range of 1 x 10⁻⁴ to 1 Pa, preferably in the range of 1 x 10⁻³ to 1 x 10⁻² Pa, the film forming rate is in the range of 2 to 10 Å/sec, by using the RF ion source "OIS One", the acceleration voltage output of the IAD ion source 7 is in the range of 500 to 1500 V, the acceleration current is in the range of 300 to 1500 mA, the bias current is in the range of 500 to 2000 mA, the introduction amount of oxygen is in the range of 20 to 60 sccm, and the introduction amount of argon is in the range of 0 to 15 sccm.

Then, the operation of the vapor deposition source 5 is stopped, and the sputtering target 52 (53) prepared in advance outside the apparatus is moved along the sputtering target introduction means 91 such as a guide rail provided inside the apparatus from the window-like entrance. It is placed on a target holder 51 located between the substrate 4 and the IAD ion source 7.

The ion source is an IAD ion source 7, and the ion beam 8 emitted from the IAD ion source 7 is irradiated on a surface of the first sputtering target 52 and the second sputtering target 53 opposite to a surface facing the substrate 4 to perform sputtering. The first sputtered particles 54 and the second sputtered particles 55 are scattered, and film formation is made on the dielectric multilayer film which is a undercoat film formed in advance on the substrate 4, and a laminate of a dielectric multilayer films 100 and a protective film 107 are formed on the substrate.

The thickness of the protective film is preferably 15 nm or less, and is preferably in the range of 1 to 10 nm, more preferably in the range of 1 to 5 nm, from the viewpoint of excluding the influence on the light reflectance of the lower layer.

Preferable film forming conditions of the protective film are as follows: the level of reduced pressure in the chamber is usually in the range of 1 x 10⁻⁴ to 1 Pa, preferably in the range of 1 x 10⁻³ to 1 x 10⁻² Pa, the film forming rate is in the range of 1 to 10 pm/sec, by using the RF ion source "OIS One" made by Optorun CO., Ltd, the acceleration voltage output of the ion beam is in the range of 500 to 1500 V, the acceleration current is in the range of 300 to 1500 mA, the bias current is in the range of 500 to 2000 mA, the introduction amount of oxygen is in the range of 20 to 60 sccm, and the introduction amount of argon is in the range of 0 to 15 sccm.

### «Optical members for on-vehicle use or outdoor use»

It is preferable that the thin film formed by the film forming method of the present invention is provided on a base material, and is used as an optical member. The optical member may be an on-vehicle or outdoor optical lens, and in particular, a lens for an on-vehicle camera (a lens forming a lens unit) is preferable.

The "on-vehicle camera" is a camera installed on the outer side of the vehicle body. It is installed in the rear part of the vehicle body and used for backward confirmation, or installed in the front part of the vehicle body and used for forward confirmation or lateral confirmation, for confirmation of the distance to the front vehicle.

Such a lens unit for an on-vehicle camera is constituted by a plurality of lenses, and more specifically, it is constituted by an object-side lens disposed on the object-side and an image-side lens group disposed on the image-side. The image-side lens unit includes a plurality of lenses and a stop provided between the lenses.

Among the plurality of lenses, the object-side lens is an exposed surface exposed to the outside air, and the optical thin film is provided on the lens having the exposed surface.

Examples of the outdoor optical member include an outdoor installation type surveillance camera, and the optical thin film is used on a lens having an exposed surface exposed to the outside air among lenses constituting the surveillance camera.

Although the embodiments of the present invention have been described and illustrated in detail, the disclosed embodiments are made for purpose of illustration and example only and not limitation. The scope of the present invention should be interpreted by terms of the appended claims.

### Examples

Hereinafter, the present invention will be specifically described by way of examples, but the present invention is not limited thereto. In addition, although the term "part" or "%" is used in examples, unless otherwise indicated, it represents "mass part" or "mass%".

### <Preparation of Film formation sample No. 1>

Sputtering film formation was performed under the following conditions using the sputtering film forming apparatus indicated in FIG. 3 and the sputtering target indicated in FIG. 5.

### <Substrate>

Glass substrate

### <Sputtering target>

First sputtering target Cr deposited, H1: 125 mm, Φ1: 285 mm
Second sputtering target SiO₂ (quartz glass), H2: 119 mm, Φ2: 50 mm

### <IAD ion source>

OTFC-1300 made by Optorun Co., Ltd.
Acceleration voltage (V): 1200
Acceleration current (mA): 1000
Neutralization current (mA): 1500

### <In the chamber>

Heating temperature (°C): 300
Level of vacuum (Pa): 2 x 10⁻²

Under the above conditions, when the ion beam irradiation time from the IAD ion source was set to 110 minutes, according to the film thickness measurement described below, a protective film mixed with Si and Cr and having a film thickness of 9 nm was formed at a film forming rate of 1.36 pm/sec.

The composition of the protective film was measured by the following X-ray photoelectron spectrometer (XPS), and had the elemental composition described in Table I.

### <Film thickness measurement>

The film thickness was measured by the following method.
(1) TiO₂ and SiO₂ are formed in a film thickness of 1/4 λ (λ = 550 nm) on a white sheet glass substrate in advance, and the light reflectance is measured.
(2) A film is formed on the TiO₂ and SiO₂ films as described in (1) above under the conditions for forming a protective film, the light reflectance is measured, and the refractive index and the film thickness of the protective film are calculated from the amount of change. The light reflectance was measured at a light wavelength of 550 nm with a spectrophotometer U-4100 manufactured by Hitachi High-Technologies Corporation.

### <XPS composition analysis>

Device name: X-ray photoelectron spectroscopy (XPS)
Device type: Quantera SXM
Device manufacturer: ULVAC-PHI
Measurement conditions: X-ray source: monochromating AlKα ray 25 W-15 kV
Level of vacuum: 5.0 x 10⁻⁸ Pa
Depth direction analysis was performed by argon ion etching. For data processing, MultiPak manufactured by ULVAC-PHI, Inc. was used.

### <Preparation of Film formation sample No. 2>

Sputtering film formation was carried out in the same manner as preparation of the film formation sample No. 1 except that the first sputtering target in which Al was vapor deposited instead of Cr was used, and Φ2 of the second sputtering target was set to 105 mm.

As a result, a protective film having a film thickness, a film forming rate and an elemental composition described in Table I was obtained.

### <Preparation of Film formation samples No. 3 to No. 12>

Sputtering film formation was carried out in the same manner as preparation of the film formation sample No. 1 except that the first sputtering target in which SUS304 was vapor deposited instead of Cr was used, and the ion beam irradiation time, H1 and Φ1 of the first sputtering target, and H2 and Φ2 of the second sputtering target were set as described in Table I and Table II.

As a result, protective films having the film thickness, the film forming rate and the elemental composition described in Tables I and II were obtained.

### <Preparation of Film formation samples No. 13 to No. 22>

Sputtering film formation was carried out in the same manner as preparation of the film formation sample No. 1 except that the first sputtering target in which Ti was vapor deposited instead of Cr was used, and the ion beam irradiation time, H1 and Φ1 of the first sputtering target, and H2 and Φ2 of the second sputtering target were set as described in Table III and Table IV.

As a result, protective films having the film thickness, the film forming rate and the elemental composition described in Tables III and IV were obtained.

### <Preparation of Film formation sample No. 23>

Sputtering film formation was carried out in the same manner as preparation of the film formation sample No. 1 except that a sputtering target was prepared and arranged as indicated in FIG. 4B. The sputtering target contains a first sputtering target using SUS304 instead of Cr, a white plate of SiO₂ (quartz) as a second sputtering target, and a white plate of TiO₂ as a third sputtering target. Further, the ion beam irradiation time, H1 and Φ1 of the first sputtering target, H2 and Φ2 of the second sputtering target, and H3 and Φ3 of the third sputtering target were set as described in Table V.

As a result, protective films having the film thickness, the film forming rate and the elemental composition described in Table V were obtained.

Tables I to V indicate the results of the sputtering conditions and the obtained film thickness, film forming rate and elemental composition.

**Table I**

| Sample No. | Sputter target | | | | Ion beam irradiation time (min) | Film thickness (nm) | Film forming rate (pm/sec) | Product | Element ratio contained in protective film (at%) | | | | | | |
|---|---|---|---|---|---|---|---|---|---|---|---|---|---|---|---|
| | 1 | 2 | H (mm) | Φ (mm) | | | | | | | | | | | |
| 1 | Cr | | 125 | 285 | 110 | 9 | 1.36 | Si+Cr | Si | Cr | O | - | - | Others | Total |
| | | SiO₂ (quartz) | 119 | 95 | | | | | 14.1 | 1.5 | 30.5 | - | - | 53.9 | 100.0 |
| 2 | Al | | 125 | 285 | 110 | 15 | 2. 27 | Si+Al | Si | Al | O | - | - | Others | Total |
| | | SiO₂ (quartz) | 119 | 105 | | | | | 20.1 | 1.7 | 42.7 | - | - | 35.5 | 100.0 |
| 3 | SUS304 | | 125 | 285 | 110 | 10 | 1. 52 | Si+Cr+Ni+Fe | Si | Fe | Ni | Cr | O | Others | Total |
| | | SiO₂ (quartz) | 119 | 50 | | | | | 15.2 | 0.3 | 0.1 | 1.7 | 33.3 | 49.5 | 100.0 |
| 4 | SUS304 | | 125 | 285 | 11 | 1 | 1. 52 | Si+Cr+Ni+Fe | Si | Fe | Ni | Cr | O | Others | Total |
| | | SiO₂ (quartz) | 119 | 50 | | | | | 15.2 | 0.3 | 0.1 | 1.7 | 33.3 | 49.5 | 100.0 |
| 5 | SUS304 | | 125 | 285 | 33 | 3 | 1. 52 | Si+Cr+Ni+Fe | Si | Fe | Ni | Cr | O | Others | Total |
| | | SiO₂ (quartz) | 119 | 50 | | | | | 15.2 | 0.3 | 0.1 | 1.7 | 33.3 | 49.5 | 100.0 |
| 6 | SUS304 | | 125 | 285 | 55 | 5 | 1.52 | Si+Cr+Ni+Fe | Si | Fe | Ni | Cr | O | Others | Total |
| | | SiO₂ (quartz) | 119 | 50 | | | | | 15.2 | 0.3 | 0.1 | 1.7 | 33.3 | 49.5 | 100.0 |

**Table II**

| Sample No. | Sputter target | | | | Ion beam irradiation time (min) | Film thickness (nm) | Film forming rate (pm/sec) | Product | Element ratio contained in protective film (at%) | | | | | | |
|---|---|---|---|---|---|---|---|---|---|---|---|---|---|---|---|
| | 1 | 2 | H (mm) | Φ (mm) | | | | | | | | | | | |
| 7 | SUS304 | | 125 | 285 | 88 | 8 | 1. 52 | Si+Cr+Ni+Fe | Si | Fe | Ni | Cr | O | Others | Total |
| | | SiO₂ (quartz) | 119 | 50 | | | | | 15.2 | 0.3 | 0.1 | 1.7 | 33.3 | 49.5 | 100.0 |
| 8 | SUS304 | | 125 | 285 | 165 | 15 | 1. 52 | Si+Cr+Ni+Fe | Si | Fe | Ni | Cr | O | Others | Total |
| | | SiO₂ (quartz) | 119 | 50 | | | | | 15.2 | 0.3 | 0.1 | 1.7 | 33.3 | 49.5 | 100.0 |
| 9 | SUS304 | | 125 | 285 | 110 | 10 | 1. 52 | Si+Cr+Ni+Fe | Si | Fe | Ni | Cr | O | Others | Total |
| | | SiO₂ (quartz) | 119 | 60 | | | | | 30.6 | 0.0 | 0.0 | 0.3 | 61.6 | 7.5 | 100.0 |
| 10 | SUS304 | | 125 | 285 | 11 | 1 | 1. 52 | Si+Cr+Ni+Fe | Si | Fe | Ni | Cr | O | Others | Total |
| | | SiO₂ (quartz) | 119 | 60 | | | | | 30.6 | 0.0 | 0.0 | 0.3 | 61.6 | 7.5 | 100.0 |
| 11 | SUS304 | | 125 | 285 | 110 | 10 | 1. 52 | Si+Cr+Ni+Fe | Si | Fe | Ni | Cr | O | Others | Total |
| | | SiO₂ (quartz) | 119 | 40 | | | | | 8.8 | 0.4 | 0.1 | 2.3 | 21.7 | 66.7 | 100.0 |
| 12 | SUS304 | | 125 | 285 | 11 | 1 | 1. 52 | Si+Cr+Ni+Fe | Si | Fe | Ni | Cr | O | Others | Total |
| | | SiO₂ (quartz) | 119 | 40 | | | | | 8.8 | 0.4 | 0.1 | 2.3 | 21.7 | 66.7 | 100.0 |

**Table III**

| Sample No. | Sputter target | | | | Ion beam irradiation time (min) | Film thickness (nm) | Film forming rate (pm/sec) | Product | Element ratio contained in protective film (at%) | | | | | | |
|---|---|---|---|---|---|---|---|---|---|---|---|---|---|---|---|
| | 1 | 2 | H (mm) | Φ (mm) | | | | | | | | | | | |
| 13 | Ti | | 125 | 285 | 110 | 11 | 1. 67 | Si+Ti | Si | Ti | O | - | - | Others | Total |
| | | SiO₂ (quartz) | 119 | 50 | | | | | 17.1 | 0.6 | 35.2 | - | - | 47.1 | 100.0 |
| 14 | Ti | | 125 | 285 | 10 | 1 | 1. 67 | Si+Ti | Si | Ti | O | - | - | Others | Total |
| | | SiO₂ (quartz) | 119 | 50 | | | | | 17. 1 | 0.6 | 35.2 | - | - | 47.1 | 100.0 |
| 15 | Ti | | 125 | 285 | 30 | 3 | 1. 67 | Si+Ti | Si | Ti | O | - | - | Others | Total |
| | | SiO₂ (quartz) | 119 | 50 | | | | | 17.1 | 0.6 | 35.2 | - | - | 47.1 | 100.0 |
| 16 | Ti | | 125 | 285 | 50 | 5 | 1. 67 | Si+Ti | Si | Ti | O | - | - | Others | Total |
| | | SiO₂ (quartz) | 119 | 50 | | | | | 17.1 | 0.6 | 35.2 | - | - | 47.1 | 100.0 |
| 17 | Ti | | 125 | 285 | 80 | 8 | 1. 67 | Si+Ti | Si | Ti | O | - | - | Others | Total |
| | | SiO₂ (quartz) | 119 | 50 | | | | | 17.1 | 0.6 | 35.2 | - | - | 47.1 | 100.0 |
| 18 | Ti | | 125 | 285 | 150 | 15 | 1. 67 | Si+Ti | Si | Ti | O | - | - | Others | Total |
| | | SiO₂ (quartz) | 119 | 50 | | | | | 17.1 | 0.6 | 35.2 | - | - | 47.1 | 100.0 |

**Table IV**

| Sample No. | Sputter target | | | | Ion beam irradiation time (min) | Film thickness (nm) | Film forming rate (pm/sec) | Product | Element ratio contained in protective film (at%) | | | | | | |
|---|---|---|---|---|---|---|---|---|---|---|---|---|---|---|---|
| | 1 | 2 | H (mm) | Φ (mm) | | | | | | | | | | | |
| 19 | Ti | | 125 | 285 | 110 | 11 | 1**.**67 | Si+Ti | Si | Ti | O | - | - | Others | Total |
| | | SiO₂ (quartz) | 119 | 80 | | | | | 26.8 | 0.2 | 53.9 | - | - | 19. 1 | 100.0 |
| 20 | Ti | | 125 | 285 | 10 | 1 | 1. 67 | Si+Ti | Si | Ti | O | - | - | Others | Total |
| | | SiO₂ (quartz) | 119 | 80 | | | | | 26.8 | 0.2 | 53.9 | - | - | 19. 1 | 100.0 |
| 21 | Ti | | 125 | 285 | 110 | 11 | 1. 67 | Si+Ti | Si | Ti | O | - | - | Others | Total |
| | | SiO₂ (quartz) | 119 | 20 | | | | | 9. 7 | 0. 8 | 20.9 | - | - | 68. 6 | 100.0 |
| 22 | Ti | | 125 | 285 | 10 | 1 | 1.67 | Si+Ti | Si | Ti | O | - | - | Others | Total |
| | | SiO₂ (quartz) | 119 | 20 | | | | | 9.7 | 0.8 | 20.9 | - | - | 68.6 | 100.0 |

**Table V**

| Sample No. | Sputter target | | | | | Ion beam irradiation time (min) | Film thickness (nm) | Film forming rate (pm/sec) | Product | Element ratio contained in protective film (at%) | | | | | | | |
|---|---|---|---|---|---|---|---|---|---|---|---|---|---|---|---|---|---|
| | 1 | 2 | 3 | H (mm) | φ (mm) | | | | | | | | | | | | |
| 23 | SUS304 | | | 125 | 285 | 110 | 11 | 1. 67 | Si+Cr+Ni+Fe+Ti | Si | Fe | Ni | Cr | Ti | O | Others | Total |
| | | SiO₂ (quartz) | | 119 | 50 | | | | | 16.1 | 0.3 | 0.1 | 1.6 | 0.7 | 36.1 | 45.1 | 100.0 |
| | | | White plate+TiO₂ | 119 | 28. 5 | | | | | | | | | | | | |

From Table I to Table V, the following were revealed. By disposing a sputtering target between a substrate an ion source, and by sputtering a surface of the sputtering target opposite to a surface facing the substrate with an ion beam and depositing a film on the substrate, it has been found that an extremely thin and homogeneous protective film may be obtained, in which the film forming rate may be controlled to be slow as compared with the conventional film forming method, and the material composition may be arbitrarily adjusted. Thus, it has been found that a film forming method and a film forming apparatus capable of arbitrarily controlling the film forming rate and the material ratio may be obtained for uniformly forming a very thin pure substance film or mixed film as a protective film.

## Claims

1. A method of forming a film on a substrate with sputtering film formation by an ion beam emitted from an ion source,
the method comprising the steps of:
disposing a sputtering target between the substrate and the ion source; and
sputtering a surface of the sputtering target opposite to a surface facing the substrate by the ion beam to form a film on the substrate.

2. The method of forming a film described in claim 1,
wherein a film forming rate of the sputtering film formation is 10 pm/sec or less.

3. The method of forming a film described in claim 1 or 2,
wherein the ion source is an ion source used for an ion assisted deposition method.

4. The method of forming a film described in any one of claims 1 to 3,
wherein an undercoat film is formed in advance on the substrate by an ion assisted deposition method using the ion source, and then the sputtering film formation is performed on the undercoat film by the ion beam emitted from the ion source.

5. The method of forming a film described in any one of claims 1 to 4,
wherein the film formed with the sputtering film formation has a thickness of 15 nm or less.

6. The method of forming a film described in any one of claims 1 to 5,
wherein the sputtering film formation is performed by simultaneously using a plurality of sputtering targets different in at least one of distance, size, and angle.

7. The method of forming a film described in any one of claims 1 to 6,
wherein the sputtering film formation is performed while rotating the sputtering target.

8. The method of forming a film described in any one of claims 1 to 7,
wherein the sputtering film formation is performed while lifting the sputtering target.

9. The method of forming a film described in any one of claims 1 to 8,
wherein a surface of the sputtering target to be sputtered has a metal surface and a glass surface.

10. The method of forming a film described in claim 9,
wherein the metal surface contains at least one element from the group consisting of Ti, Cr, Ni and Al.

11. The method of forming a film described in claim 9,
wherein the glass surface contains SiO₂ as a main component and contains at least one element from the group consisting of Ta, Zr and Na.

12. A film forming apparatus used for the method of forming a film described in any one of claims 1 to 11,
comprising a means for arranging the sputtering target between the substrate and the ion source at a desired timing, a surface of the sputtering target opposite to a surface facing the substrate is sputtered by an ion beam emitted from the ion source to form a film on the substrate.
